# NEUE EUROPÄISCHE PATENTSCHRIFT

(11) **EP 0 418 423 B2**
(45) Veröffentlichungstag und Bekanntmachung des Hinweises auf die Entscheidung über den Einspruch: **09.12.1998**
(45) Hinweis auf die Patenterteilung: 07.02.1996
(21) Anmeldenummer: 89117581.2
(22) Anmeldetag: 22.09.1989
(51) Int. Cl.: H01L 21/306, H01L 21/308, G02B 6/32

(54) **Verfahren zum anisotropen Ätzen von Silizium**
Process for etching silicon anisotropically
Procédé d'attaque anisotrope de silicium

(43) Veröffentlichungstag der Anmeldung: 27.03.1991
(73) Patentinhaber: SIEMENS AKTIENGESELLSCHAFT, 80333 München (DE)
(72) Erfinder: Dietrich, Ralf, D-8000 München 90 (DE); Hörmann, Ewald, D-8150 Holzkirchen (DE); Kuhlman, Werner, D-8000 München 90 (DE); Schmidt-Sodingen, Gisela, D-8000 München 71 (DE); Steinhauser, Karl-August, Dr., D-8000 München 90 (DE); Westhauser, Elmar, D-8000 München 70 (DE)

(56) Entgegenhaltungen:
- FR-A- 2 500 642
- US-A- 4 692 998
- US-A- 4 863 560
- PATENT ABSTRACTS OF JAPAN vol. 11, no. 5 (P-533)(2452) 08 Januar 1987, & JP-A-61 182008 (YOKOGAWA ELECTRIC CORPORATION)
- APPLIED PHYSICS LETTERS. vol. 51, no. 26, 28 Dezember 1987, NEW YORK US Seiten 2189 - 2191; W.J. GRANDE ET AL.: "ONE-STEP TWO LEVEL ETCHING TECHNIQUE FOR MONOLITHIC INTEGRATED OPTICS."
- T.K. Tewksbury et al., IEEE Transactions on components, hybrids and manufacturing technology, Vol. CHMT-10, Number 1, March 1987, pages 111-121
- E.Bassous, R.Kurth, IBM TDB 19(6), November 1976, Seiten 2311-2312

## Beschreibung

Die Erfindung betrifft ein Verfahren zum anisotropen Ätzen von Silizium nach dem Oberbegriff des Anspruchs 1.

Aus der US-PS 4,863,560 ist bereits ein Verfahren zum anisotropen Ätzen von Silizium bekannt, bei dem unter Verwendung einer geeigneten Maskierung und eines geeigneten Ätzmittels aus der Oberfläche eines Silizium-Wafers ineinander übergehende Strukturen unterschiedlicher Größe herausgeätzt werden, wobei die Strukturen durch entsprechende, übereinander aufgebrachte Maskierungen in Grob- und Feinstrukturen zerlegt, in zwei Ätzschritten nacheinander aus dem Silizium-Wafer herausgeätzt werden.

Aus der Druckschrift APPLIED PHYSICS LETTERS, BAND 51, HEFT 26, 28. DEZ. 1987, S. 2189-2191 ist eine Standard-Lithographietechnik bekannt, bei der zum Erzeugen von unterschiedlichen Ätztiefen in Halbleiter-Wafern das Maskenaufbringen, Maskenstrukturieren und Ätzen zweimal erfolgt. Dort ist auch auf die bei diesem Verfahren auftretenden Probleme, wie Kontamination zwischen den Ätzschritten, Strukturieren der zweiten Maske auf einer nicht planen Oberfläche und Überdeckung der Strukturebenen, hingewiesen.

Einkristallines Silizium wird wegen seiner guten mikromechanischen Eigenschaften immer häufiger als Ausgangsmaterial für die unterschiedlichsten mechanischen Komponenten verwendet. Die Anwendungsmöglichkeiten reichen von Drucksensoren über Düsen beispielsweise für Tintenstrahldrucker bis zu elektrooptischen Wandlermodulen in hybrider Aufbautechnik.

Eine besonders präzise und auch kostengünstige Methode der Strukturierung stellt das anisotrope Ätzen von einkristallinem Silizium beispielsweise in Kalilauge oder Äthylendiamin dar. Dabei stört allerdings oft die starke Unterätzung von konvexen bzw. vorspringenden Ecken. Solche konvexe Ecken sind aber bei einer für bestimmte Anwendungen notwendigen Formgebung, bei der ineinander übergehende Strukturen unterschiedlicher Größe aus einer Siliziumscheibe herausgeätzt werden müssen, unvermeidbar. Eine derartige Struktur wird beispielsweise bei optischen Sende- und Empfangsmodulen zum Einlegen einer Glasfaser und einer Kugellinse benötigt. Ein solcher Sende- und Empfangsmodul ist in der DE-OS 38 09 396 näher beschrieben. Bei diesem optoelektronischen Wandlermodul sind die einzelnen optischen, optoelektronischen und elektrooptischen Komponenten unmittelbar auf einem Siliziumsubstrat angeordnet. Zum Einlegen der Glasfaser und der Kugellinse ist der Si-Wafer so strukturiert, daß eine schmale V-Nut für die Glasfaser in eine breite V-Nut zur Aufnahme der Kugellinse einmündet.

Bei den derzeitigen anisotropen Ätzungen von Silizium wird beim Design der Masken darauf geachtet, störende vorspringende bzw. konvexe Ecken zu vermeiden. Falls das nicht möglich ist, kann man durch Maskenvorhalt die Eckenunterätzung kompensieren (IEEE Transactions on Electron Devices, Vol. ED-25, No. 10, October 1978, Seiten 1185 bis 1193). Da der Wert der Eckenunterätzung von der Ätzzeit abhängt, ist dieses Verfahren allerdings nicht sonderlich genau. Außerdem werden die Möglichkeiten von mikromechanischen Strukturen durch diese Maßnahmen eingeschränkt.

Der Erfindung liegt die Aufgabe zugrunde, diese Nachteile zu vermeiden und ein Mehrschrittverfahren beim anisotropen Ätzen von Silizium zu schaffen, mit dem es möglich ist, die Unterätzung von konvexen bzw. vorspringenden Ecken zu unterbinden.

Diese Aufgabe wird erfindungsgemäß durch ein Verfahren mit den Merkmalen des Anspruchs 1 gelöst.

Vorteilhafte Ausgestaltungen bzw. Weiterbildungen der Erfindung sind Gegenstand zusätzlicher Ansprüche.

Bei dem erfindungsgemäßen Verfahren werden die bereits geätzten Strukturen geschützt, so daß konvexe bzw. vorspringende Ecken an den Übergängen zwischen den Einzelstrukturen nicht unterätzt werden können.

Gemäß einer vorteilhaften Weiterbildung der Erfindung können zwei Unterstrukturen bereits vor dem anisotropen Ätzen in Form einer vergrabenen Maske aufgebracht werden.

Anhand eines in den Figuren der Zeichnung dargestellten Ausführungsbeispiels wird das erfindungsgemäße Verfahren im folgenden näher erläutert. Es zeigen
- FIG 1: eine perspektivische Ansicht eines strukturierten Si-Wafers,
- FIG 2a und 2b: eine Draufsicht auf den Si-Wafer nach FIG 1 mit herkömmlicher Strukturierung,
- FIG 3a und 3b: eine Draufsicht auf den Si-Wafer nach FIG 1 mit erfindungsgemäßer Strukturierung und
- FIG 4a bis 4f: die Prozeßfolge bei Verwendung einer vergrabenen Maske.

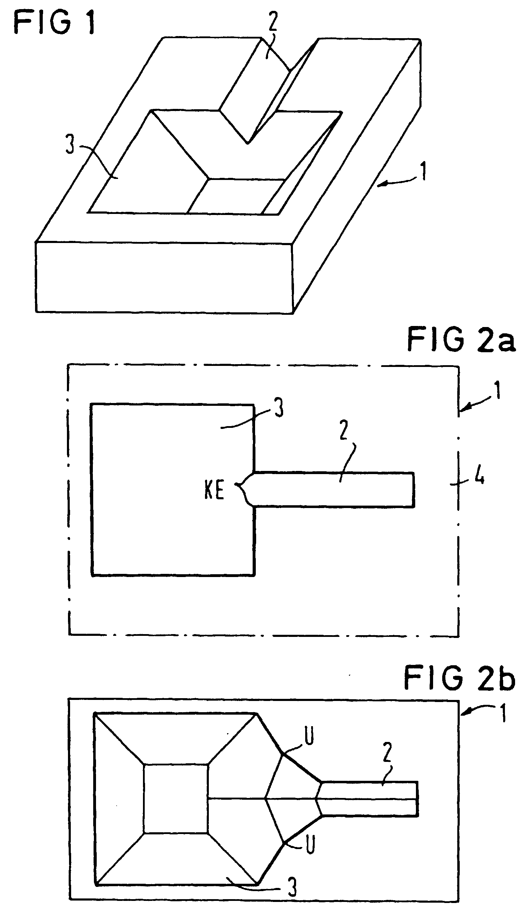

Das erfindungsgemäße Mehrschrittätzverfahren wird an dem in FIG 1 dargestellten Beispiel der Einmündung einer schmalen V-Nut 2 in eine breite V-Nut 3, die aus einem Si-Wafer 1 anisotrop herausgeätzt sind, detailliert beschrieben. Eine derartige Struktur wird bei optischen Sende- und Empfangsmodulen zum Einlegen einer Glasfaser und einer Kugellinse benötigt, wie eingangs im Zusammenhang mit der DE-OS 38 09 396 bereits erläutert worden ist.

Beim üblichen in FIG 2a und 2b dargestellten Herstellungsverfahren wird auf einem (100)-orientierten Si-Wafer 1 parallel zur kristallographischen (110)-Richtung eine Si-Oxid- oder Nitridmaskierung 4 aufgebracht und dann in Kalilauge oder einer Mischung von Brenzkatechin, Äthylendiamin und Wasser geätzt. Allen bekannten anisotropen Ätzmischungen ist gemeinsam, daß die (111)-Ebenen erheblich langsamer als alle anderen Ebenen angegriffen werden. Dadurch entstehen V-förmige Ätzgruben 2 und 3, die von konkav aufeinanderstoßenden (111)-Ebenen begrenzt sind.An den beiden konvexen Ecken KE (FIG 2a) treten aber starke Unterätzungen U auf (FIG 2b), so daß es später unmöglich ist, eine Kugellinse definiert in die große V-Nut 3 einzulegen.

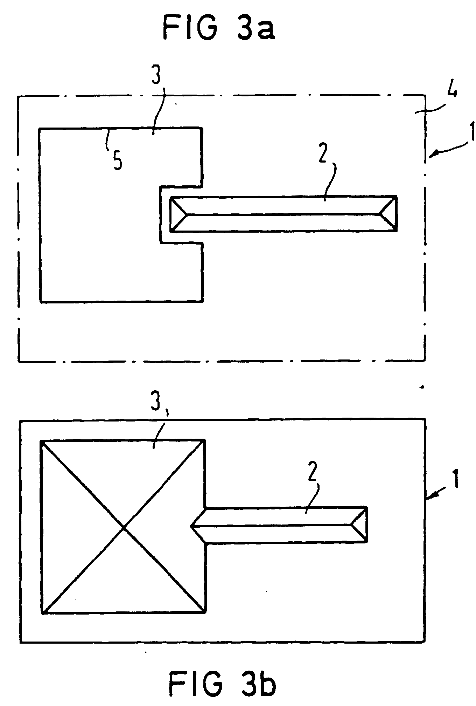

Die unerwünschte Unterätzung wird vermieden, wenn man die beiden V-Nuten 2, 3 getrennt in zwei Schritten ätzt, wie in den FIG 3a und 3b gezeigt ist. Nachdem die kleine V-Nut 2 in an sich bekannter Technologie herausgeätzt worden ist, wird die ganze Siliziumscheibe 1 passiviert (z.B. thermisch oxidiert) und die Maskenöffnung 5 in der Maske 4 für die große V-Nut 3 erzeugt. Durch eine geeignete Struktur dieser Maske 4 kann vermieden werden, daß die Passivierungsschicht in der kleinen V-Nut 2 angegriffen wird (FIG 3a). Anschließend wird in einer anisotropen Ätzung die große V-Nut 3 herausgeätzt. Dabei wird die 'Einstülpung' der Oxidmaske 4 bei der kleinen V-Nut 2 unterätzt, bis ein quadratisches pyramidenförmiges Loch 3 entstanden ist (FIG 3b). Infolge der Abdeckschicht 4 auf der kleinen V-Nut 2 wird jetzt die konkave Ecke nicht unterätzt, wie man gut mit einer rasterelektronischen Aufnahme nachweisen kann.

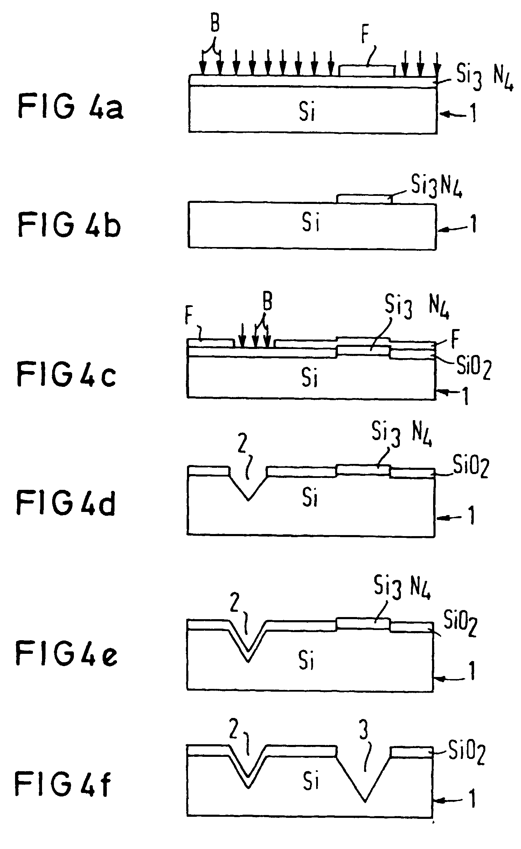

Bei dem erfindungsgemäßen Mehrschrittätzverfahren liegt vor dem zweiten Ätzschritt ein bereits strukturierter Silizium-Wafer 1 vor, der dann beispielsweise schon die V-Nut 2 enthält. Zur photolithographischen Erzeugung der weiteren Maskierungsschicht 4 für den zweiten Ätzschritt wird dieser Wafer 1 entsprechend belackt. Bedingt durch beispielsweise die scharfen Kanten der V-Nut kann es möglich sein, daß die Lackhaftung nicht vollkommen einwandfrei ist. Gemäß einer Weiterbildung der Erfindung ist daher vorgesehen, bereits vor der ersten anisotropen Ätzung eine Maske für den zweiten Ätzschritt zu vergraben, um sie dann nach der ersten Ätzung wieder freizulegen. Eine solche vergrabene Maske kann aber nicht direkt erstellt werden, weil diese Maskierungsschicht auch das Innere beispielsweise der kleinen V-Nuten schützen muß, die aber erst später geätzt werden. Es ist jedoch topologisch möglich, das Negativ der für den zweiten Ätzschritt benötigten Maske zu vergraben, die dann vor dem zweiten Ätzschritt zur endgültigen Ätzmaske'umkopiert' wird. Beim Umkopieren verhindert die Negativmaske das Aufwachsen der neuen Maskierungsschicht, so daß nach dem Ablösen der Negativmaske die gewünschte Positivmaske stehen bleibt. Möglich ist dieses Verfahren z.B. mit einer vergrabenen Siliziumnitridmaske, die bei einer anschließenden thermischen Oxidation oder auch Dotierung nicht angegriffen wird. Siliziumnitrid wird nämlich deutlich langsamer oxidiert als Silizium. Daher kann die dünne Oxidschicht auf dem Siliziumnitrid abgeätzt werden, ohne die SiO₂-Maske auf dem Silizium nennenswert anzugreifen. Anschließend kann dann das Siliziumnitrid herausgeätzt werden, so daß nur die SiO₂-Maske als weitere Maskierungsschicht 4 zum Herausätzen der folgenden Einzelstruktur, beispielsweise der großen V-Nut, stehen bleibt. Die einzelnen Prozeßschritte sind am Beispiel der Materialkombination Si₃N₄-SiO₂ in FIG 4a bis 4f dargestellt.

Die FIG 4a zeigt das Belacken mit einer Photolackschicht F und das Belichten in Pfeilrichtung B der auf dem Si-Wafer 1 befindlichen Si₃N₄-Schicht beispielsweise zum Ätzen einer großen V-Nut. FIG 4b zeigt das Strukturieren der Si₃N₄-Schicht. FIG 4c zeigt das Oxidieren unter Bildung der SiO₂-Schicht, das Belacken in Form der Photolackschicht F und das durch Pfeile B angedeutete Belichten für z.B. eine kleine V-Nut. FIG 4d beschreibt das SiO₂-Ätzen und das Ätzen der kleinen V-Nut 2. In FIG 4e ist das Oxidieren der kleinen V-Nut 2 unter Bildung der SiO₂-Schicht bzw. die Bildung der weiteren Maskierungsschicht 4 zum Ätzen der großen V-Nut 3 dargelegt und FIG 4f zeigt als letzten Schritt das Wegätzen der Si₃N₄-Schicht und das Herausätzen der großen V-Nut 3 aus dem Si-Wafer 1.

## Patentansprüche

1. Verfahren zum anisotropen Ätzen von Silizium, bei dem unter Verwendung einer geeigneten Maskierung und eines geeigneten Ätzmittels aus der Oberfläche eines (100)-orientierten Silizium-Wafers nebeneinander angeordnete, ineinander übergehende Strukturen unterschiedlicher Größe und unterschiedlicher Tiefe herausgeätzt werden, wobei die Struktruren die Gestalt einer kleineren V-Nut und einer größeren V-förmigen Vertiefung haben und durch entsprechende Maskierung in sich überlappende Einzelstrukturen zerlegt in mindestens zwei Ätzschritten nacheinander aus dem SilizIum-Wafer herausgeätzt werden, **dadurch gekennzeichnet,** daß zwischen den Ätzschritten die bereits geätzten Einzelstrukturen (2) durch eine weitere Maskierungsschicht (4) zum Herausätzen der folgenden Einzelstrukturen (3) abgedeckt werden, wobei
- aus einem mit einer entsprechenden Maskierung versehenen Silizium-Wafer (1) als Einzelstruktur in einem ersten Ätzschritt die Kleinere V-Nut (2) herausgeätzt wird,
- anschließend der Silizium-Wafer (1) und die Kleinere V-Nut (2) mit einer weiteren Maskierung (4) für die größere V-förmige Vertiefung (3) mit einer Einstülpung in die Maskenöffnung (5) für die größere V-förmige Vertiefung (3) bei der kleineren V-Nut (2) abgedeckt werden, und
- dann in einem zweiten Ätzschritt als Einzelstruktur die größere V-förmige Vertiefung (3), in die die kleinere V-Nut (2) einmündet, herausgeätzt wird, wobei die Einstülpung unterätzt wird.

2. Verfahren nach Ansprüche 1, **dadurch gekennzeichnet,** daß die weitere Maskierung(4) als Negativ in Form einer vergrabenen Maske vor dem anisotropen Ätzen auf dem Silizium-Wafer (1) aufgebracht wird.

3. Verfahren nach Anspruch 2, **dadurch gekennzeichnet,** daß als Negativ einer vergrabenen Maske eine Siliziummitridschicht auf den Silizium-Wafer (1) aufgebracht wird.

4. Verfahren nach Anspruch 2 oder 3, **dadurch gekennzeichnet,** daß die weitere Maskierung (4) durch thermische Oxidation der vorstrukturierten Teile des Silizium-Wafers (1) erzeugt wird.

## Claims

1. Method process for the anisotropic etching of silicon, in which, using a suitable masking and a suitable etchant, adjacently disposed which merge into one another and have structures different sizes and different depths are etched out of the surface of a (100)-oriented silicon wafer the structures having the form of a smaller V-groove and of a larger V-shaped recess and the structures, divided into mutually overlapping individual structures by suitable masking, being consecutively etched out of the silicon wafer in at least two etching steps, characterized in that, between the etching steps, the individual structures (2) already etched are covered by a further masking layer (4) in order to etch out the subsequent individual structures (3),
- the smaller V-groove (2) being etched out of a silicon wafer (1) provided with a suitable masking as an individual structure in a first etching step,
- the silicon wafer (1) and the smaller V-groove (2) subsequently being covered with a further masking (4) for the larger V-shaped recess (3) with a re-entrant in the mask opening (5) for the larger V-shaped recess (3) in the case of the smaller V-groove (2), and
- the larger V-shaped recess (3), into which the smaller V-groove (2) opens, is etched out as an individual structure in a second etching step, the re-entrant being undercut.

2. Method according to Claim 1, characterized in that the further masking (4) is applied to the silicon wafer (1) as a negative in the form of a buried mask before the anisotropic etching.

3. Method according to Claim 2, characterized in that a silicon nitride layer is applied to the silicon wafer (1) as a negative of a buried mask.

4. Method according to Claim 2 or 3, characterized in that the further masking (4) is produced by thermal oxidation of the prestructured parts of the silicon wafer (1).

## Revendications

1. Procédé d'attaque anisotrope de silicium, dans lequel on forme par attaque de la surface d'une galette de silicium à orientation (100), en utilisant un masque approprié et un réactif approprié d'attaque, des structures sans interruption de l'une à l'autre de dimensions différentes et de profondeurs différentes, les structures ayant la forme d'une petite rainure en V et d'un renfoncement plus grand en forme de V et dans lequel on forme par attaque de la galette de silicium, en au moins deux étapes d'attaque successives, les structures par masquage adéquat décomposées en structures distinctes se chevauchant, caractérisé en ce que l'on revêt, entre les étapes d'attaque, les structures (2) déjà attaquées, d'une autre couche (4) de masquage pour former par attaque les structures (3) suivantes,
- l'on forme par attaque d'une galette (1) de silicium et munie d'un masque adéquat, comme structure dans une première étape d'attaque, la petite rainure (2) en V,
- puis on recouvre la galette (1) de silicium et la petite rainure (2) en V d'un autre masque (4) destiné au renfoncement (3) plus grand en forme de V et ayant un retroussement dans lequel débouche l'ouverture (5) de masque ménagée pour le renfoncement plus grand en forme de V à la petite rainure (2) en forme de V, et
- ensuite, on forme par attaque dans une seconde étape d'attaque, comme structure, le renfoncement (3) plus grand en forme de V, dans lequel débouche la petite rainure (2) en V, avec attaque latérale du retroussement.

2. Procédé suivant la revendication 1, caractérisé en ce que l'on dépose l'autre masque (4) comme négatif sous forme d'un masque enterré, avant l'attaque anisotrope, sur la galette (1) de silicium.

3. Procédé suivant la revendication 2, caractérisé en ce que l'on dépose comme négatif d'un masque enterré, une couche de nitrure de silicium sur la galette (1) de silicium.

4. Procédé suivant la revendication 2 ou 3, caractérisé en ce que l'on produit l'autre masque (4) par oxydation thermique des parties, structurées au préalable, de la galette (1) de silicium.
